# EUROPÄISCHE PATENTSCHRIFT

(11) **EP 0 408 773 B1**
(45) Veröffentlichungstag und Bekanntmachung des Hinweises auf die Patenterteilung: **07.07.1993**
(21) Anmeldenummer: 89113039.5
(22) Anmeldetag: 15.07.1989
(51) Int. Cl.: H05K 3/00

(54) **Verfahren zur Herstellung von starre und flexible Bereiche aufweisenden Leiterplatten oder Leiterplatten-Innenlagen**
Process for the production of circuit boards or inner layers of circuit boards containing rigid and flexible parts
Procédé pour la fabrication de plaques à circuits ou de couches internes de plaques à circuit contenant des parties rigides et flexibles

(43) Veröffentlichungstag der Anmeldung: 23.01.1991
(73) Patentinhaber: Firma Carl Freudenberg, 69469 Weinheim (DE)
(72) Erfinder: Kober, Horst, D-6940 Weinheim (DE); Horch, Uwe, D-7070 Schwäbisch-Gmünd (DE)

(56) Entgegenhaltungen:
- DE-A- 3 302 857
- DE-A- 3 515 549
- DE-C- 3 140 061
- FR-A- 2 374 818

## Beschreibung

Die Erfindung betrifft ein Verfahren zur Herstellung von starre und flexible Bereiche aufweisenden Leiterplatten oder starre und flexible Bereiche aufweisenden Innenlagen für die Herstellung von Mehrlagen-Leiterplatten. Dabei werden mindestens eine starre und mindestens eine flexible Isoliermaterialschicht mit Hilfe von Verbundfolien sandwichartig miteinander verbunden; mindestens die flexible Isoliermaterialschicht trägt dabei elektrische Leiterbahnen.

Leiterplatten der genannten Art wie auch Verfahren zu deren Herstellung sind bekannt. Ein derartiges Verfahren geht aus der DE-OS 35 15 549 hervor, wobei die starre Isoliermaterialschicht in den Übergangsbereichen starr/flexibel mit durchgehenden Schlitzen vor dem Verpressen versehen werden muß. Um während der Herstellung des Leiterplatten-Verbundes das Eindringen von Chemikalien und anderen Fremdstoffen zwischen den nicht verklebten starren und flexiblen Materialschichten zu verhindern, werden diese Schlitze durch eine Kupferfolie abgedichtet. Nach dem Ätzen der Kupferfolie liegen die Schlitze jedoch wiederum frei, so daß das Eindringen von Chemikalien in den sich anschließenden Verfahrensschritten wieder möglich ist.

Ferner besteht die Gefahr, daß, wenn das flexible Material im Schlitzbereich nicht unterstützt ist, dieses in den Schlitz einsinken kann, was zu Schwierigkeiten durch Unterstrahlung (Belichtungsfehler) beim Leiterbildprozeß führen kann. Ferner kann es beim Laminieren einer Abdeckfolie auf die flexible Leiterseite zu Eindellungen und sogar Leiterbahnrissen im Schlitzbereich kommen.

Die Aufgabe der vorliegenden Erfindung besteht darin, ein Verfahren zur Herstellung von starren und flexible Bereiche aufweisenden Leiterplatten bzw. Innenlagen für Mehrlagen-Schaltungen der eingangs genannten Art anzugeben, bei welchen an der Stelle, wo später sich der flexible Bereich befindet, ein Fensterbereich vorgesehen wird, wobei beim Ausbilden des später abzunehmenden Füllstücks, das diesen Fensterbereich während der Fertigung abdeckt,
- auf die Fertigung von Nuten oder Schlitzen verzichtet werden kann,
- sowohl das Füllstück leicht heraustrennbar ausgestaltet ist als auch dennoch eine sichere Abdichtung des flexiblen Bereichs zum Isoliermaterial hin während der naßchemischen Herstellungsprozesse gewährleistet ist und
- eine absolute Planlage zwischen der Oberfläche des Füllstücks und dem es umgebenden, starren Isoliermaterial besteht.

Die Lösung dieser Aufgabe besteht in einem Verfahren, das die kennzeichnenden Merkmale des Anspruchs 1 trägt. Vorteilhafte Weiterführungen des Verfahrens sind in den Unteransprüchen enthalten.

In die starre Isoliermaterialschicht wird vor dem Laminieren des Verbundes ein Fenster in der Größe des später flexiblen Bereiches gestanzt. Dabei ist es gleichgültig, ob diese Schicht bereits mit Kupfer kaschiert ist oder nicht. Direkt nach dem Stanzen wird das ausgestanzte Teilstück wieder paßgenau in das verbleibende Fenster der Isolierschicht zurückgedrückt. Dies kann in einer vorteilhaften Ausgestaltung der Erfindung ohne besonderen technischen Aufwand dadurch erreicht werden, daß die Auswerferplatte des Stanzwerkzeugs so ausgebildet ist, daß sie in dem Maße zurückfedert, daß das ausgestanzte Teil als Füllstück in seinen ursprünglichen Sitz vollständig zurückgedrückt wird.

Selbstverständlich ist dieser Vorgang auch durch ein separates Werkzeug durchführbar, ohne den Umfang der Erfindung zu verlassen.

Die extreme Dichtigkeit der Stanzfugen nach dem Ausstanzen und Wiedereinsetzen des Füllstücks in das Fenster war von vornherein nicht zu erwarten und resultiert vermutlich daraus, daß beim Stanzen von Isolierschichtstoffen für Leiterplatten die Stanzkanten oder -fugen etwas ausfasern und daher beim Wiedereinsetzen des Füllstücks eine paßgenau Abdichtung der Stanzfugen bewirken. Dieses Ausfasern tritt bei allen bekannten Isolierschichtstoffen für Leiterplatten auf, wie z.B. Epoxid-Hartglasgewebe, Phenolharzpapier oder Polyamid-Hartglasgewebe. Ein zweiter Abdichtungseffekt wird dadurch hervorgerufen, daß beim Laminieren des Lagenaufbaus die Glasübergangstemperatur des Isoliermaterials überschritten wird, wobei dieser Werkstoff auch im Fugenbereich plastisch wird und gleichsam eine Versiegelung der Fugen bewirkt, jedoch ohne Verklebung derselben.

Die erfindungsgemäß hergestellten Stanzfugen sind nach Wiedereinsetzen des Füllstücks so dicht, daß alle in der Leitenplatten-Technik verwendeten Chemikalien sie nicht zu durchdringen vermögen; auch unter dem Mikroskop sind nur geringe Vertiefungen und Erhebungen sichtbar, so daß von einer Planlage des Füllstücks bezüglich der es umgebenden Bereiche gesprochen werden kann.

Die Verbundfolie, mit deren Hilfe die Materialschichten in den starren Bereichen verklebt werden, wird üblicherweise über den später flexiblen Bereichen der Leiterplatten ausgeschnitten, so daß die Verklebung der starren Isoliermaterialschichten nicht über dem Stanzbereich erfolgt. Die Ausrichtung der Einzelschichten zueinander und der Leiterbilder zum Stanzspalt erfolgt in bekannterweise mit Hilfe von Positionierungslöchern, die in das starre Material und in die Verbundfolie in einem Arbeitsgang mit dem Stanzen der Fenster hergestellt werden.

Die Einzellagen der nach diesem Verfahren laminierten Nutzen sind überall, speziell in den Randzonen, verklebt, außer in dem flexiblen Teil der Schaltung. Der flexible Teil ist somit hermetisch abgeschlossen, und der Nutzen weist eine geschlossene Oberfläche der Außenlagen auf, die es erlaubt, ihn in der gleichen wirtschaftlichen Weise weiter zu bearbeiten, die bei der Herstellung starrer Leiterplatten üblich ist. Nach der Ausbildung der Leiterbilder auf den Außenlagen kann das starre Füllstück leicht vom flexiblen Teil abgezogen werden.

Eine vorteilhafte Weiterbildung der Erfindung besteht darin, die Verbundfolie auf die Isoliermaterialschicht vor dem Stanzen anzuheften. Erst beim Ausstanzen der Füllstücke aus der Isoliermaterialschicht wird gleichzeitig die Verbundfolie im später flexiblen Bereich ausgestanzt. Dieser Folienteil - auf den wieder eingepaßten Füllstücken befindlich - kann dann leicht entfernt werden. Damit erzielt man eine größere Paßgenauigkeit der Verbundfolie zum Stanzspalt, ohne daß zeitraubende Positionierarbeit und ein getrenntes, vorheriges Ausstanzen der Folie allein in den flexiblen Bereichen notwendig ist.

Das erfindungsgemäße Verfahren erlaubt es, beliebige Zusammenstellungen von Leiterplattenanordnungen auszubilden; diese Freiheit bei der Zuordnung der einzelnen Schichten zueinander eröffnet neue Möglichkeiten des Leiterplattenaufbaus, wie in den Abbildungen beispielhaft gezeigt und im folgenden beschrieben wird:

Es zeigen:
Abb.I die Draufsicht auf einen starr/flexiblen Nutzen mit Leiterbahnbildern vor der Konturbearbeitung;
Abb.II einen Schnitt längs der Linie A-A durch den Nutzen gemäß Abb.I, jedoch vor der Erstellung der Leiterbilder.

Die Draufsicht der Abb.I ist mit Blick auf die starre Isoliermaterialschicht 3 ausgerichtet. Diese besteht aus Epoxidharz-Glasgewebe. Die Linie 21 deutet die Kontur der starren Bereiche und die Linie 8 die Kontur des flexiblen Bereichs an. Die Löcher 24 dienen zur Registrierung der Leiterbilder 11 zur gestanzten Aussparung 22 (Abb.I und II). In die Aussparung 22 ist paßgenau ein Teilstück 23 der starren Isoliermaterialschicht 3 eingefügt. Die flexible Isoliermaterialschicht 1, eine Polyimid-Folie, und die starre Isoliermaterialschicht 3 werden mit Hilfe der Verbundfolie 2 miteinander verklebt.

Die flexible und die starre Isoliermaterialschicht sind dabei mit je einer Kupferschicht 12 versehen.

Insbesondere aus Abb.II wird ersichtlich, daß die Erfindung auf alle denkbaren Varianten des Schichtaufbaus anwendbar ist:

Es kann, z.B. aus 2 Lagenaufbauten, gemäß Abb.II mit Hilfe einer weiteren Verbundfolie ein vierlagiger, symmetrischer Lagenaufbau ausgebildet werden, wobei die flexiblen Innenlagen in der Mitte liegen.

Die starre Isoliermaterialschicht kann selbst eine mehrlagige Leiterplatte sein, so daß man eine viellagige, starr-flexible Leiterplatte mit einer flexiblen Außenlage erhält.

Der starr-flexible Verbund, wie er in Abb.II dargestellt ist, kann ebenfalls als eine Innenlage von viellagigen starr-flexiblen Leiterplatten eingesetzt werden.

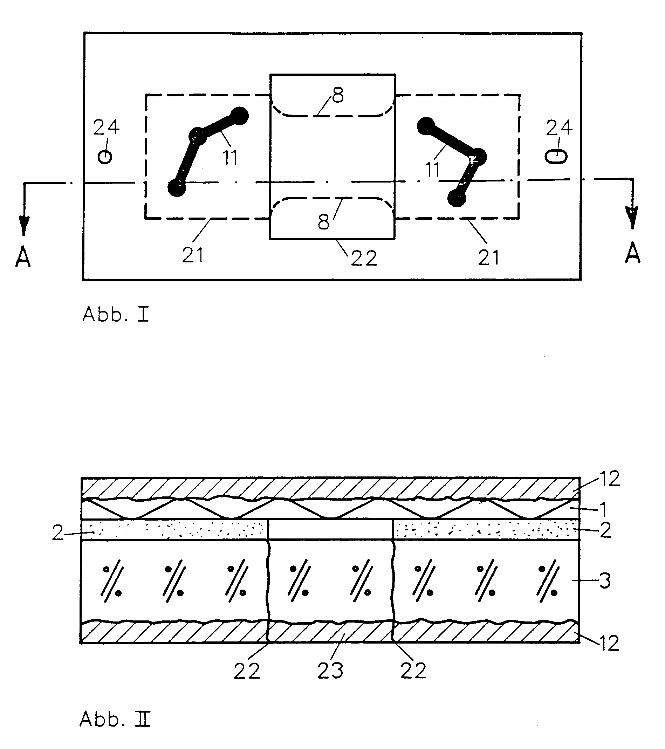

## Patentansprüche

1. Verfahren zur Herstellung von starre und flexible Bereiche (21, 8) aufweisenden Mehrlagen-Leiterplatten oder Leiterplatten-Innenlagen, wobei ein nach dem Laminieren der Einzellagen mittels einer diese verklebenden Verbundfolie (2) und nach dem Ausbilden der Leiterbahnen entfernbares Füllstück (23) in einer starren Isoliermaterialschicht (3) an der jeweiligen Stelle des flexiblen Bereiches geschaffen wird, dadurch gekennzeichnet, daß aus der starren Isoliermaterialschicht vor dem Laminieren der Einzellagen an jedem flexibel zu gestaltenden Bereich ein in seinen Abmessungen mit diesem Bereich identisches Flächenstück herausgestanzt und sogleich danach als Füllstück auf aufgekehrtem Wege in das Stanzfenster paßgenau wieder eingesetzt wird und dort bis zur Fertigstellung der Leiterplatte oder der Leiterplatten-Innenlage verbleibt.

2. Verfahren nach Anspruch 1, dadurch gekennzeichnet, daß das Füllstück, ohne das Stanzwerkzeug zu verlassen, durch die federnde Rückstellkraft einer darunter liegenden Auswerferplatte wieder in das Stanzfenster eingedrückt wird.

3. Verfahren nach Anspruch 1 oder 2, dadurch gekennzeichnet, daß die die Einzellagen verklebende Verbundfolie ohne Aussparungen vollflächig auf die Isoliermaterialschicht angeheftet, zusammen mit dem Füllstück ausgestanzt und der auf dem Füllstück befindliche Teil der Verbundfolie danach entfernt wird.

## Claims

1. A method for producing multilayer printed circuit boards or inner layers of printed circuit boards having rigid and flexible areas (21, 8), there being created in a rigid insulant layer (3) at the respective site of the flexible area a filling piece (23) which can be removed after lamination of the individual layers by means of a bonding ply (2) which bonds the latter and after the construction of the printed conductors, characterised in that before laminating the individual layers there is punched out of the rigid insulant layer at each area to be configured flexibly a subarea which is dimensionally identical to this area, is thereafter immediately reinserted in the reverse direction true to size into the punched window as filling piece, and remains there until completion of the printed circuit board or the inner layer of the printed circuit board.

2. A method according to claim 1, characterised in that, without leaving the punch tool, the filling piece is pressed again into the punched window by the resilient restoring force of an ejection plate located therebelow.

3. A method according to claim 1 or 2, characterised in that the bonding ply bonding the individual layers is attached over its entire surface without openings to the insulant layer and punched out together with the filling piece, and in that the part of the bonding ply located on the filling piece is thereafter removed.

## Revendications

1. Procédé pour la fabrication de plaques à circuits multicouches, ou de couches inférieures de plaques à circuits, comportant des zones rigides et flexibles (21, 8), selon lequel une partie de remplissage (23) est formée dans une couche de matière isolante rigide (3) à l'endroit correspondant de la zone flexible et peut être enlevé après la stratification des différentes couches au moyen d'une feuille de liaison (2) assurant leur collage et après la formation des voies conductrices, caractérisé en ce que, à partir de la couche de matière isolante rigide, avant la stratification des différentes couches, on enlève par poinçonnage dans chaque zone flexible à former, un élément superficiel ayant des dimensions identiques à cette zone et on le remet ensuite à nouveau en place exactement, par un processus inversé, comme partie de remplissage dans la fenêtre de poinçonnage où il est maintenu jusqu'à terminaison de la fabrication de la plaque à circuit ou de la couche intérieure de plaque à circuit.

2. Procédé selon la revendication 1, caractérisé en ce que la partie de remplissage, sans quitter l'outil de poinçonnage, est à nouveau enfoncée dans la fenêtre de poinçonnage par la force élastique de rappel exercée par une plaque d'éjection située en-dessous.

3. Procédé selon la revendication 1 ou 2, caractérisé en ce que la feuille de liaison assurant le collage des différentes couches adhère sans évidements et par toute sa surface à la couche de matière isolante, elle est découpée par poinçonnage en même temps que la partie de remplissage.
